# EUROPÄISCHE PATENTSCHRIFT

(11) **EP 2 804 457 B1**
(45) Veröffentlichungstag und Bekanntmachung des Hinweises auf die Patenterteilung: **20.04.2016**
(21) Anmeldenummer: 13167690.0
(22) Anmeldetag: 14.05.2013
(51) Int. Cl.: H05K 13/00, G01R 31/00

(54) **Vorrichtung zu einem Transport oder zu einem Transport und zu einer Bearbeitung von Leiterplatten**
Device for transporting or for transporting and processing of circuit boards
Dispositif de transport et de traitement de plaques conductrices

(43) Veröffentlichungstag der Anmeldung: 19.11.2014
(73) Patentinhaber: Pematech AG, 78315 Radolfzell (DE)
(72) Erfinder: Müller, Alf, 78351 Bodman-Ludwigshafen (DE)
(74) Vertreter: Daub, Thomas

(56) Entgegenhaltungen:
- WO-A1-92/21451
- US-A- 4 957 044
- US-A1- 2002 133 937
- US-B1- 6 174 382

## Beschreibung

### Stand der Technik

Die Erfindung betrifft eine Vorrichtung zu einem Transport oder zu einem Transport und zu einer Bearbeitung von Leiterplatten nach dem Oberbegriff des Anspruchs 1.

Es ist bereits in der WO 92/21451 A1 eine Vorrichtung zu einem Transport oder zu einem Transport und zu einer Bearbeitung von Leiterplatten vorgeschlagen worden, die eine Transporteinheit umfasst, die zu einer Hochkantförderung vorgesehen ist und die ein Transportumschlingungsmittel umfasst.

Vorrichtungen zu einem Transport oder zu einem Transport und zu einer Bearbeitung von Leiterplatten, bei denen die Leiterplatten während eines Transports vertikal ausgerichtet sind, sind ebenfalls aus den Dokumenten US 2002/133937 A1 und US 4,957,044 A bekannt. Weiterhin offenbart auch das Dokument US 6,174,382 B1 eine Vorrichtung die zum Transport oder zu einem Transport und zu einer Bearbeitung von Leiterplatten geeignet ist.

Die Aufgabe der Erfindung besteht insbesondere darin, eine gattungsgemäße Vorrichtung mit einer hohen Flexibilität hinsichtlich einer Zuführung von Leiterplatten und/oder hinsichtlich eines Transports von Leiterplatten zu ermöglichen.

Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

### Vorteile der Erfindung

Die Erfindung geht aus von einer Vorrichtung zu einem Transport oder zu einem Transport und zu einer Bearbeitung von Leiterplatten, mit zumindest einer Transporteinheit, die zu einer Hochkantförderung vorgesehen ist und die zumindest ein Transportumschlingungsmittel aufweist.

Es wird vorgeschlagen, dass das Transportumschlingungsmittel zumindest eine Transportlagerfläche zur Abstützung der Leiterplatten zumindest während eines Transports aufweist. Der Begriff "Hochkantförderung" soll hier insbesondere eine Förderung von Leiterplatten entlang einer Transportrichtung der Transporteinheit definieren, bei der das Element während eines Transports vertikal ausgerichtet ist. Unter "vertikal ausgerichtet" soll hier insbesondere eine Ausrichtung der Leiterplatte verstanden werden, in der die Haupterstreckungsebene der Leiterplatte zumindest im Wesentlichen senkrecht zu einer Bodenkontaktfläche der Vorrichtung ausgerichtet ist. Der Begriff "Bodenkontaktfläche" soll hier insbesondere eine Fläche der Vorrichtung definieren, mittels derer die Vorrichtung auf einem Untergrund abstellbar ist. Die Bodenkontaktfläche wird vorzugsweise von einer Fläche eines Standfußes der Vorrichtung, insbesondere eines Standfußes einer Tragrahmeneinheit der Vorrichtung, gebildet. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Ebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist.

Unter einem "Transportumschlingungsmittel" soll hier insbesondere ein Element verstanden werden, das zu einer Übertragung von Antriebskräften ein Antriebselement, insbesondere ein Antriebsrad, zumindest teilweise umschlingt und somit von dem Antriebselement antreibbar ist. Das Transportumschlingungsmittel kann hierbei als Transportriemen, als Transportband, als Transportkette usw. ausgebildet sein. Der Begriff "Transportlagerfläche" soll hier insbesondere eine Fläche des Transportumschlingungsmittels definieren, die dazu vorgesehen ist, zu einer Übertragung von Transportkräften direkt an den Leiterplatten anzuliegen. Die Transportlagerfläche kann hierbei von einer einzigen, insbesondere ebenen, Fläche gebildet sein, die zumindest im Wesentlichen quer zu einer Hochkantachse der Transporteinheit ausgerichtet ist. Es ist jedoch auch denkbar, dass die Transportlagerfläche sich aus mehreren Teilflächen zusammensetzt, die zumindest im Wesentlichen quer zueinander verlaufen, wie beispielsweise abgewinkelt zueinander usw. Es kann somit beispielsweise eine V-förmige Transportlagerfläche o. dgl. gebildet werden. Weitere, einem Fachmann als sinnvoll erscheinende Ausgestaltungen der Transportlagerfläche sind ebenfalls denkbar. Besonders bevorzugt verläuft die Transportlagerfläche zumindest im Wesentlichen quer zur Hochkantachse der Transporteinheit. Unter "im Wesentlichen quer" soll hier insbesondere eine Ausrichtung einer Richtung und/oder einer Achse relativ zu einer Bezugsrichtung und/oder einer Bezugsachse verstanden werden, wobei die Ausrichtung der Richtung und/oder der Achse zumindest verschieden von einer zumindest im Wesentlichen parallelen Ausrichtung zur Bezugsrichtung und/oder zur Bezugsachse ist und insbesondere windschief oder senkrecht zur Bezugsrichtung und/oder zur Bezugsachse ist. Unter einer "Hochkantachse" soll hier insbesondere eine Achse der Transporteinheit verstanden werden, die zumindest im Wesentlichen senkrecht zur Bodenkontaktfläche der Vorrichtung ausgerichtet ist. Vorzugsweise ist die Hochkantachse der Transporteinheit als Vertikalachse ausgebildet. Mittels der erfindungsgemäßen Ausgestaltung der Vorrichtung kann vorteilhaft eine bauteilschonende Förderung der Leiterplatten ermöglicht werden. Es kann vorteilhaft eine geringe Knickbelastung der Leiterplatte während eines Transports der Leiterplatte mittels der erfindungsgemäßen Vorrichtung ermöglicht werden. Zudem kann vorteilhaft infolge einer Hochkantförderung eine Durchbiegung der Leiterplatte während eines Transports vorteilhaft zumindest weitestgehend vermieden werden. Ferner kann infolge der Hochkantförderung eine Verschmutzung der Leiterplatte, wie beispielsweise durch Staub oder durch Späne infolge einer Kontaktierung mittels Kontaktnadelelementen, während eines Transports vorteilhaft vermieden werden. Ferner können vorteilhaft Bauteile zu einer Übertragung von Transportkräften eingespart werden. Somit kann vorteilhaft eine kompakte Transporteinheit bzw. eine kompakte Vorrichtung realisiert werden.

Weiterhin umfasst die Vorrichtung zumindest eine Schwenkeinheit, die zumindest einen Abschnitt der Transporteinheit schwenkbar um eine Schwenkachse lagert. Bei einer Schwenkbewegung des Abschnitts der Transporteinheit mittels der Schwenkeinheit werden eine Teilstrecke der Transporteinheit, an der zumindest ein Transportumschlingungsmittel, ein Transport- und/oder Führungselement der Transporteinheit und eine Antriebseinheit der Transporteinheit angeordnet sind, relativ zu weiteren Abschnitten der Transporteinheit um die Schwenkachse geschwenkt. Die Schwenkachse kann hierbei zumindest im Wesentlichen parallel und/oder zumindest im Wesentlichen senkrecht zur Hochkantachse verlaufen. Mittels der erfindungsgemäßen Ausgestaltung der Vorrichtung kann vorteilhaft eine hohe Flexibilität hinsichtlich einer Zuführung von Leiterplatten und/oder hinsichtlich eines Transports von Leiterplatten ermöglicht werden. Es kann beispielsweise infolge eines Schwenkens eines Abschnitts bzw. eines Teilbereichs der Transporteinheit um eine zumindest im Wesentlichen senkrecht zur Hochkantachse verlaufende Schwenkachse eine Ablage von Leiterplatten nach einem Transport in einem Horizontallagermagazin ermöglicht werden usw.

Des Weiteren wird vorgeschlagen, dass die Transportlagerfläche zumindest im Wesentlichen senkrecht zur Hochkantachse verläuft. Zu einem Antrieb des Transportumschlingungsmittels umfasst die Transporteinheit zumindest eine Antriebseinheit, die zumindest ein Antriebsrad umfasst, das von dem Transportumschlingungsmittel zumindest teilweise umschlungen ist. Zudem kann die Antriebseinheit Stützrollen, Spannrollen usw. umfassen, die dazu vorgesehen sind, das Transportumschlingungsmittel zumindest während einer Transportbewegung zu stützen und/oder zu spannen. Mittels der erfindungsgemäßen Ausgestaltung kann vorteilhaft eine kompakte Ausgestaltung der erfindungsgemäßen Vorrichtung erreicht werden. Zudem kann vorteilhaft eine große Transportlagerfläche realisiert werden, mittels deren die Leiterplatte transportiert und geführt werden kann.

Ferner wird vorgeschlagen, dass das Transportumschlingungsmittel als Transportriemen ausgebildet ist, der einen polygonalen Querschnitt aufweist. Vorzugsweise ist das Transportumschlingungsmittel hierbei endlos ausgebildet bzw. weist einen in sich geschlossenen Verlauf auf. Besonders bevorzugt umfasst der Transportriemen einen rechteckigen oder einen viereckigen Querschnitt. Es ist jedoch auch denkbar, dass der Transportriemen einen 5-eckigen Querschnitt aufweist, der zumindest auf einer Seite eine V-förmige Aufnahme bildet. Weitere, einem Fachmann als sinnvoll erscheinende Ausgestaltungen sind ebenfalls denkbar. Ferner kann die Transporteinheit zumindest ein Stützelement aufweisen, das das als Transportriemen ausgebildete Transportumschlingungsmittel, betrachtet entlang der Hochkantachse, zumindest teilweise überdeckt. Es kann vorteilhaft eine Führungsfläche im Bereich des als Transportriemen ausgebildeten Transportumschlingungsmittels erreicht werden. Zudem kann das als Transportriemen ausgebildete Transportumschlingungsmittel vor Verschmutzungen geschützt werden. Hierbei ist es denkbar, dass an dem Stützelement ein Schmutzabweiserelement, wie beispielsweise eine Gummilippe angeordnet ist, das somit eine Verschmutzung des als Transportriemen ausgebildeten Transportumschlingungsmittels verringern bzw. weitestgehend vermeiden kann. Mittels der erfindungsgemäßen Ausgestaltung kann vorteilhaft eine flache Bauweise der Transporteinheit, insbesondere des Transportumschlingungsmittels, erreicht werden.

Zudem wird vorgeschlagen, dass die Transporteinheit zumindest ein Transport- und/oder Führungselement aufweist, das als Führungsschiene ausgebildet ist. Hierbei sind das Transportumschlingungsmittel und das Transport- und/oder Führungselement bevorzugt entlang der Hochkantachse relativ zueinander beabstandet angeordnet. Zu einem Transport der Leiterplatten sind die Leiterplatten, betrachtet entlang der Hochkantachse, vorzugsweise zwischen dem Transportumschlingungsmittel und dem Transport- und/oder Führungselement angeordnet. Somit liegen die Leiterplatten während eines Transports entlang der Transportrichtung bevorzug zumindest teilweise an dem Transportumschlingungsmittel und teilweise an dem Transport- und/oder Führungselement an. Vorzugsweise umfasst das als Führungsschiene ausgebildete Transport- und/oder Führungselement zumindest eine Stütz- und/oder Transportfläche. Besonders bevorzugt ist die Stütz- und/oder Transportfläche dazu vorgesehen, zumindest eine Stütz- und/oder Haltekraft auf die Leiterplatten auszuüben, deren Hauptkraftkomponente zumindest im Wesentlichen parallel zur Hochkantachse verläuft. Unter "im Wesentlichen parallel" soll hier insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Der Begriff "Hauptkraftkomponente" soll hier insbesondere eine Komponente einer Kraft, insbesondere eine vektorielle Komponente einer Kraft, definieren, die prozentual gesehen, den größten Anteil hinsichtlich eines Betrags der Kraft definiert. Hierbei wirken insbesondere mehr als 40 %, bevorzugt mehr als 50 % und besonders bevorzugt mehr als 65 % der Stütz- und/oder Haltekraft entlang einer zumindest im Wesentlichen quer zur Hochkantachse verlaufenden Richtung in zumindest einem zwischen dem Transport- und/oder Führungselement und dem Transportumschlingungsmittel angeordneten Zustand der Leiterplatte auf die Leiterplatte, insbesondere während eines Transports oder während eines Haltens der Leiterplatten. Vorzugsweise sind das Transport- und/oder Führungselement und das Transportumschlingungsmittel hinsichtlich einer Position relativ zueinander einstellbar. Hierbei können das Transport- und/oder Führungselement und das Transportumschlingungsmittel stufenlos oder in Stufen hinsichtlich einer Position relativ zueinander verstellbar sein. Zu einer Arretierung des Transport- und/oder Führungselements und des Transportumschlingungsmittels in einer Position relativ zueinander umfasst die Vorrichtung hierbei bevorzugt zumindest eine Arretiereinheit, die dazu vorgesehen ist, das Transport- und/oder Führungselement und das Transportumschlingungsmittel mittels einer formschlüssigen und/oder mittels einer kraftschlüssigen Verbindung in einer Position zu arretieren. Die Arretiereinheit kann hierbei von einteilig mit einer Einstelleinheit zu einer Einstellung einer Position des Transport- und/oder Führungselements und des Transportumschlingungsmittels ausgebildet sein. Somit ist die Transporteinheit vorzugsweise einstellbar auf verschiedene Größen und Formate von Leiterplatten. Mittels der erfindungsgemäßen Ausgestaltung kann besonders vorteilhaftes Handling von Leiterplatten mittels der erfindungsgemäßen Vorrichtung erreicht werden.

Des Weiteren wird vorgeschlagen, dass das als Führungsschiene ausgebildete Transport- und/oder Führungselement entlang einer zumindest im Wesentlichen parallel zur Hochkantachse verlaufenden Bewegungsachse relativ zum Transportumschlingungsmittel beweglich gelagert ist. Hierbei ist das als Führungsschiene ausgebildete Transport- und/oder Führungselement vorzugsweise rahmenfest an einem Tragrahmenelement der Transporteinheit angeordnet. Das Tragrahmenelement an sich ist jedoch bevorzugt beweglich relativ zu weiteren Bauteilen, insbesondere relativ zu einem Hauptrahmen, der Transporteinheit gelagert. Somit ist das als Führungsschiene ausgebildete Transport- und/oder Führungselement mittels des Tragrahmenelements der Transporteinheit vorzugsweise beweglich relativ zum Transportumschlingungsmittel an einem Hauptrahmen der Transporteinheit gelagert. Mittels der erfindungsgemäßen Ausgestaltung kann vorteilhaft eine präzise Ausrichtung der Leiterplatten während eines Transports entlang der Transportrichtung der Transporteinheit ermöglicht werden. Somit kann vorteilhaft eine platzsparende Förderung von Leiterplatten realisiert werden. Zudem kann insbesondere vorteilhaft eine präzise Aufnahme und Übergabe der Leiterplatten an weitere Arbeitsstationen der erfindungsgemäßen Vorrichtung ermöglicht werden.

Ferner wird vorgeschlagen, dass das als Führungsschiene ausgebildete Transport- und/oder Führungselement zumindest eine Führungsnut umfasst, in der die Leiterplatten zumindest während eines Transports geführt werden. Besonders bevorzugt liegt die Stütz- und/oder Transportfläche des als Führungsschiene ausgebildeten Führungs- und/oder Transportelements hierbei zu einer Führung der Leiterplatten während eines Transports direkt an den Leiterplatten an. Hierbei liegt die Stütz- und/oder Transportfläche des als Führungsschiene ausgebildeten Führungs- und/oder Transportelements vorzugsweise direkt an einer zumindest im Wesentlichen senkrecht zu einer Haupterstreckungsebene der Leiterplatten verlaufenden Fläche der Leiterplatten oder an einer Übergangskante zwischen der zumindest im Wesentlichen senkrecht zu einer Haupterstreckungsebene der Leiterplatten verlaufenden Fläche und einer zumindest im Wesentlichen parallel zur Haupterstreckungsebene verlaufenden Fläche der Leiterplatten an. Unter einer "Haupterstreckungsebene" soll hier insbesondere eine Ebene der Leiterplatten verstanden werden, in der die Leiterplatten eine maximale Erstreckung aufweisen. Das Führungs- und/oder Transportelement ist bevorzugt als oberes Führungs- und/oder Transportelement ausgebildet, während das Transportumschlingungsmittel vorzugsweise als unteres Führungs- und/oder Transportelement ausgebildet ist. Vorzugsweise ist zumindest die Stütz- und/oder Transportfläche des als Führungsschiene ausgebildeten Führungs- und/oder Transportelements aus einem reibungsmindernden Werkstoff gebildet oder mit einer reibungsmindernden Schicht versehen. Vorzugsweise wird die Stütz- und/oder Transportfläche von einer eine Führungsnut des Transport- und/oder Führungselements begrenzenden Fläche des als Führungsschiene ausgebildeten Transport- und/oder Führungselements gebildet. Bevorzugt weist die Führungsnut des als Führungsschiene ausgebildeten Transport- und/oder Führungselements eine U-förmige Ausgestaltung auf.

In einer alternativen Ausgestaltung der erfindungsgemäßen Vorrichtung ist es denkbar, dass das als Führungsschiene ausgebildete Transport- und/oder Führungselement zwei Stütz- und/oder Transportflächen aufweist, die relativ zueinander beweglich gelagert sind. Hierdurch kann eine Einstellung der Stütz- und/oder Transportflächen an zumindest eine Abmessung, insbesondere eine Stärke, der Leiterplatten ermöglicht werden. Insbesondere weist die Führungsnut, betrachtet entlang einer zumindest im Wesentlichen senkrecht zur Hochkantachse verlaufenden Richtung, eine Aufnahmebreite auf, die kleiner ist als 10 mm, bevorzugt kleiner ist als 8 mm und besonders bevorzugt kleiner ist als 6 mm. Vorzugsweise weist die Nut, betrachtet entlang einer zumindest im Wesentlichen senkrecht zur Hochkantachse verlaufenden Richtung, eine Aufnahmebreite auf, die einen Wert zwischen 0,2 mm und 6 mm aufweist. Mittels der erfindungsgemäßen Ausgestaltung kann vorteilhaft eine sichere Führung der Leiterplatten während eines Transports ermöglicht werden. Es kann vorteilhaft ein ungewolltes Herauskippen bzw. Herausfallen der Leiterplatten aus dem Transport- und/oder Führungselement verhindert werden. Mittels der erfindungsgemäßen Ausgestaltung kann besonders vorteilhaft eine präzise Führung der Leiterplatten während eines Transports der Leiterplatten ermöglicht werden. Somit kann vorteilhaft eine stabile Anordnung der Leiterplatten zu einem Transport und/oder zu einer Bearbeitung der Leiterplatten ermöglicht werden.

Zudem wird vorgeschlagen, dass die Vorrichtung zumindest eine Linearbewegungseinheit umfasst, die dazu vorgesehen ist, zumindest einen Abschnitt der Transporteinheit translatorisch entlang einer Linearbewegungsachse zu lagern. Besonders bevorzugt verläuft die Linearbewegungsachse zumindest im Wesentlichen senkrecht zur Hochkantachse. Vorzugsweise verläuft die Linearbewegungsachse zudem zumindest im Wesentlichen senkrecht zur Transportrichtung der Transporteinheit. Mittels der erfindungsgemäßen Ausgestaltung kann vorteilhaft eine Weichenfunktion beispielsweise zu einer Aussortierung von Leiterplatten oder zu einer Verbindung zweier parallel verlaufender Transportstreckenabschnitte der Transporteinheit ermöglicht werden.

Ferner wird vorgeschlagen, dass die Vorrichtung zumindest eine Hochkantprüfeinheit umfasst, der die Leiterplatten mittels der Transporteinheit hochkant zuführbar sind und mittels derer die Leiterplatten in einer hochkant angeordneten Position prüfbar sind. Bevorzugt verläuft eine Bewegungsrichtung, entlang der Prüfelemente der Hochkantprüfeinheit beweglich sind, zumindest im Wesentlichen senkrecht zur Hochkantachse. Es kann vorteilhaft eine Prüfung von Leiterplatten auf einem geringen Bauraum ermöglicht werden. Zudem kann vorteilhaft ein Verschmutzungsgrad von Leiterplatten, der Prüfergebnisse beeinflussen könnte, möglichst gering gehalten werden, da durch die Hochkantausrichtung der Leiterplatten vorteilhaft ein Anhaften bzw. ein Liegenbleiben von Schmutzpartikeln in einem zu prüfenden Bereich gering gehalten werden kann. Insbesondere in Kombination mit der Stütz- und/oder Transportfläche des Transport- und/oder Führungselements kann vorteilhaft eine stabile Positionierung zu einer Prüfung der Leiterplatte erreicht werden. Zudem kann mittels einer Hochkantprüfung der Leiterplatten eine Gefahr eines Kurzschlusses infolge von Metallspänen vorteilhaft gering gehalten werden, da die Metallspäne nicht auf den zu prüfenden Leiterplatten liegen bleiben können.

Zudem wird vorgeschlagen, dass die Vorrichtung zumindest eine Hochkantbestückungseinheit umfasst, der die Leiterplatten mittels der Transporteinheit hochkant zuführbar ist und mittels derer die Leiterplatten in einer hochkant angeordneten Position bestückbar sind. Bevorzugt verläuft eine Bewegungsrichtung, entlang der Bestückungselemente der Hochkantbestückungseinheit beweglich sind, zumindest im Wesentlichen senkrecht zur Hochkantachse. Es kann vorteilhaft eine Bestückung von Leiterplatten auf einem geringen Bauraum ermöglicht werden. Zudem kann vorteilhaft ein Verschmutzungsgrad von Leiterplatten, der eine Bestückung beeinflussen könnte, möglichst gering gehalten werden, da durch die Hochkantausrichtung der Leiterplatten vorteilhaft ein Anhaften bzw. ein Liegenbleiben von Schmutzpartikeln in einem zu bestückenden Bereich gering gehalten werden kann. Insbesondere in Kombination mit der Stütz- und/oder Transportfläche des Transport- und/oder Führungselements kann vorteilhaft eine stabile Positionierung zu einer Bestückung der Leiterplatten erreicht werden.

Die erfindungsgemäße Vorrichtung soll hierbei nicht auf die oben beschriebene Anwendung und Ausführungsform beschränkt sein. Insbesondere kann die erfindungsgemäße Vorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine erfindungsgemäße Vorrichtung in einer schematischen Darstellung,
- Fig. 2: eine Detailansicht einer Transporteinheit und einer mit der Transporteinheit verbundenen Hochkantprüfeinheit der erfindungsgemäßen Vorrichtung in einer schematischen Darstellung,
- Fig. 3: eine weitere Detailansicht der Hochkantprüfeinheit in einer schematischen Darstellung,
- Fig. 4: eine Detailansicht der Transporteinheit der erfindungsgemäßen Vorrichtung in einer schematischen Darstellung,
- Fig. 5: eine Detailansicht einer Schwenkeinheit der erfindungsgemäßen Vorrichtung in einer schematischen Darstellung,
- Fig. 6: eine Detailansicht der Schwenkeinheit zusammen mit einer Linearbewegungseinheit der erfindungsgemäßen Vorrichtung in einer schematischen Darstellung und
- Fig. 7: eine Detailansicht eines Transportumschlingungsmittels der Transporteinheit in einer schematischen Darstellung.

### Beschreibung des Ausführungsbeispiels

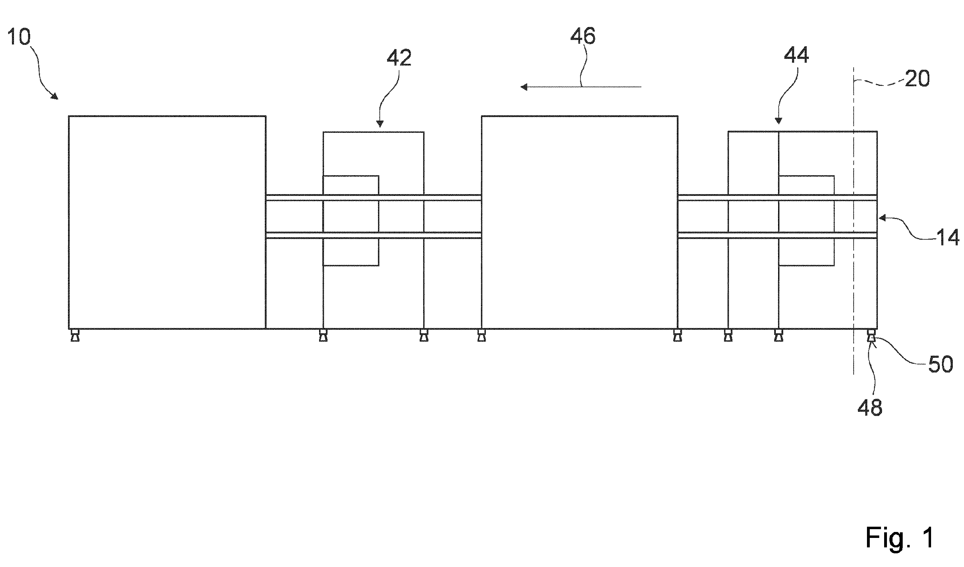

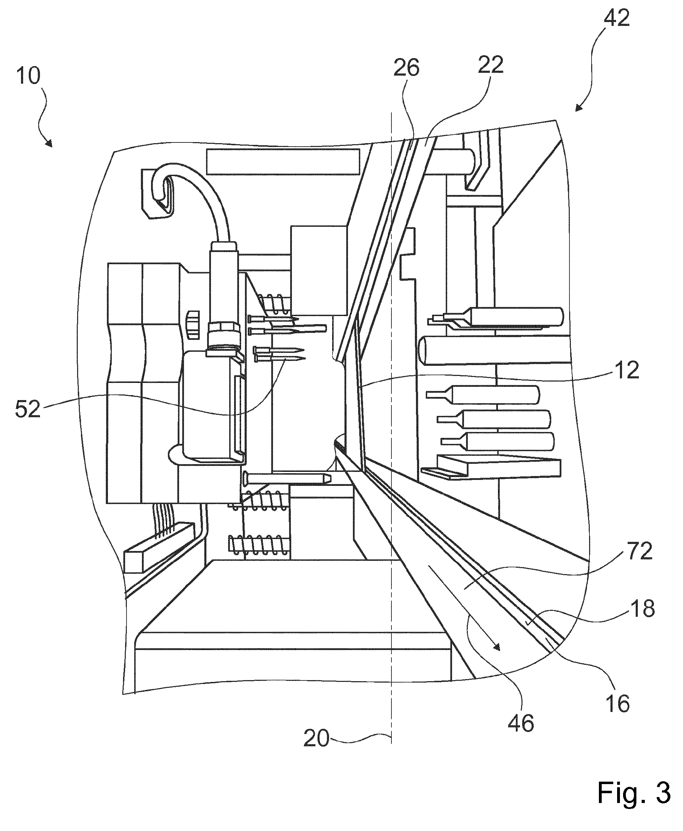

Figur 1 zeigt eine Vorrichtung 10 zu einem Transport oder zu einem Transport und zu einer Bearbeitung von Leiterplatten 12. In den Figuren ist jeweils lediglich eine Leiterplatte 12 zur Erläuterung der Funktionen der Vorrichtung 10 dargestellt. Die Vorrichtung 10 umfasst verschiedene Arbeitsstationen, in denen die Leiterplatten 12 beispielsweise bestückt, geprüft und/oder gereinigt werden. Die Vorrichtung 10 ist somit als Leiterplattenvorrichtung ausgebildet. Die einzelnen Arbeitsstationen sind bei der Vorrichtung 10 als Hochkantbestückungseinheit 44 und als Hochkantprüfeinheit 42 ausgebildet. Es ist jedoch auch denkbar, dass die Vorrichtung 10 alternativ oder zusätzlich weitere Arbeitsstationen aufweist, wie beispielsweise eine Hochkantreinigungseinheit, die entlang einer Transportrichtung 46 der Transporteinheit 14 zwischen der Hochkantbestückungseinheit 44 und der Hochkantprüfeinheit 42 angeordnet ist, usw. Mittels der Hochkantbestückungseinheit 44 werden die Leiterplatten 12 mit elektronischen Bauteilen bestückt. Hierbei erfolgt die Bestückung der Leiterplatten 12, bis auf eine vertikale Ausrichtung der Hochkantbestückungseinheit 44, zumindest im Wesentlichen auf eine, einem Fachmann bereits bekannte Art und Weise. Die bestückten Leiterplatten 12 werden zu einer Prüfung der Hochkantprüfeinheit 42 zugeführt, in der die Leiterplatten 12 auf eine Funktionalität geprüft werden. Hierbei werden Kontaktnadelelemente 52 (vgl. Figur 3) der Hochkantprüfeinheit 42 mit den einzelnen Leiterplatten 12 in Kontakt gebracht, um eine Prüfung der Leiterplatten 12 auf Funktionalität zu ermöglichen. Hierbei werden die Kontaktnadelelemente 52 entlang einer zumindest im Wesentlichen senkrecht zur Hochkantachse 20 einer Transporteinheit 14 der Vorrichtung 10 verlaufenden Richtung bewegt. Ein Prüfvorgang erfolgt hierbei, bis auf eine vertikale Ausrichtung der Hochkantprüfeinheit 42, zumindest im Wesentlichen auf eine, einem Fachmann bereits bekannte Art und Weise. Die Hochkantbestückungseinheit 44 und die Hochkantprüfeinheit 42 sind entlang der Transportrichtung 46 der Transporteinheit 14 hintereinander angeordnet. Es ist jedoch auch denkbar, dass die Hochkantbestückungseinheit 44 und die Hochkantprüfeinheit 42 eine andere, einem Fachmann als sinnvoll erscheinende Anordnung relativ zueinander aufweisen.

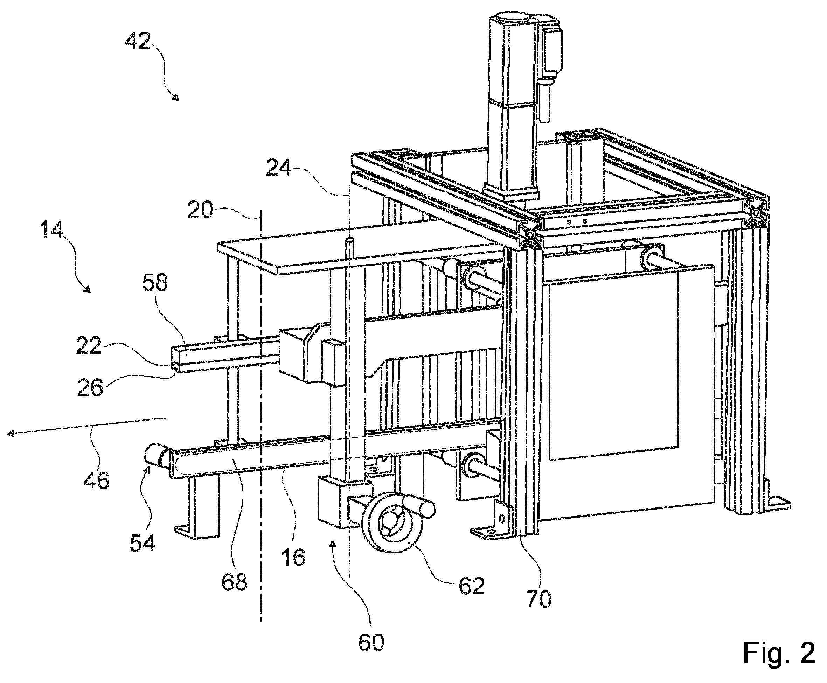

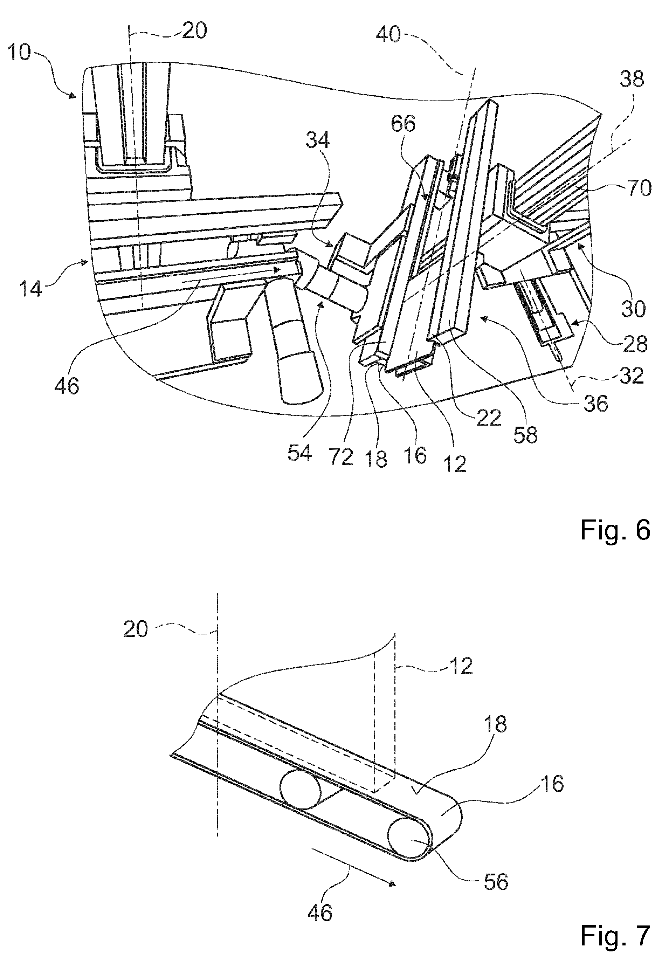

Zu einer Zuführung der Leiterplatten 12 zu den einzelnen Arbeitsstationen umfasst die Vorrichtung 10 zumindest die Transporteinheit 14, die zu einer Hochkantförderung vorgesehen ist und die zumindest ein Transportumschlingungsmittel 16 aufweist (vgl. Figuren 2 und 7). Die Leiterplatten 12 werden somit vertikal ausgerichtet mittels der Transporteinheit 14 entlang der Transportrichtung 46 der Transporteinheit 14 transportiert. Das Transportumschlingungsmittel 16 weist hierzu zumindest eine Transportlagerfläche 18 zur Abstützung der Leiterplatten 12 zumindest während eines Transports auf. Die Transportlagerfläche 18 verläuft zumindest im Wesentlichen senkrecht zur Hochkantachse 20 der Transporteinheit 14. Die Hochkantachse 20 ist zumindest im Wesentlichen senkrecht zu einer Bodenkontaktfläche 48 der Vorrichtung 10 ausgerichtet. Die Bodenkontaktfläche 48 wird von einer Fläche zumindest eines Standfußes 50 der Vorrichtung 10 gebildet.

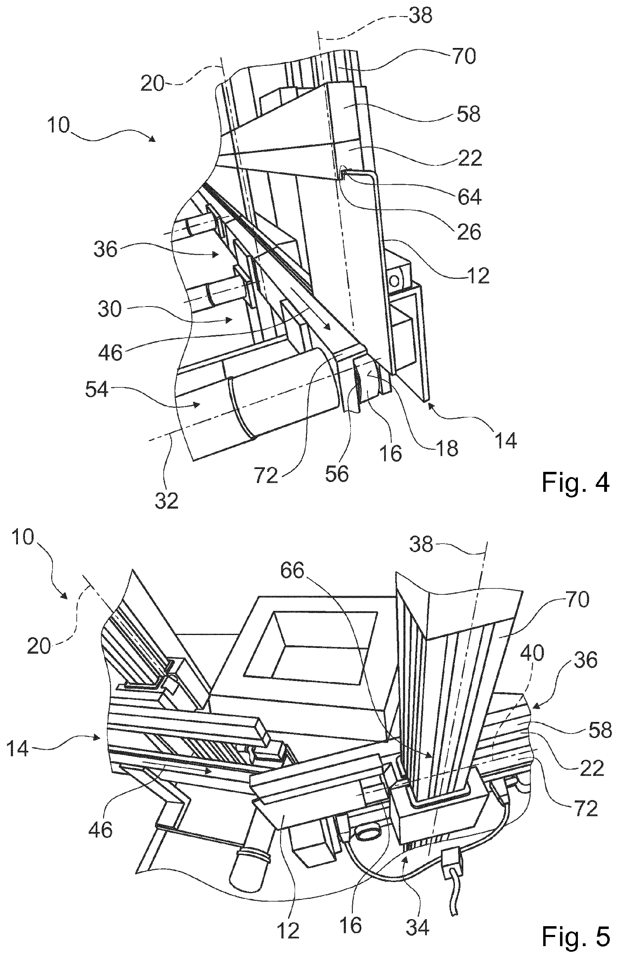

Das Transportumschlingungsmittel 16 ist als Transportriemen ausgebildet, der einen polygonalen Querschnitt aufweist. Hierbei kann das Transportumschlingungsmittel 16 Längsrillen zu einer Führung und/oder zu einer Aufnahme der Leiterplatten 12 aufweisen oder andere, einem Fachmann als sinnvoll erscheinende Führungs- und/oder Aufnahmeoberflächenstrukturen. Es ist jedoch auch denkbar, dass das als Transportriemen ausgebildete Transportumschlingungsmittel 16 eine zumindest im Wesentlichen ebene Oberflächenstruktur aufweist. Das Transportumschlingungsmittel 16 ist an einem Tragrahmenelement 68 der Transporteinheit 14 angeordnet. Das Tragrahmenelement 68 ist hierbei ortsfest an einem Hauptrahmenelement 70 der Transporteinheit 14 angeordnet. Hierbei verläuft eine Haupterstreckungsrichtung des Tragrahmenelements 68 zumindest im Wesentlichen senkrecht zur Hochkantachse 20 der Transporteinheit 14. Zu einem Antrieb des Transportumschlingungsmittels 16 weist die Vorrichtung 10 zumindest eine Antriebseinheit 54 auf (vgl. Figur 2). Die Antriebseinheit 54 ist als Elektromotoreinheit ausgebildet. Es ist jedoch auch denkbar, dass die Antriebseinheit 54 eine andere, einem Fachmann als sinnvoll erscheinende Ausgestaltung aufweist, wie beispielsweise eine Ausgestaltung als Strömungsmotoreinheit usw. Die Antriebseinheit 54 umfasst zumindest ein Antriebsrad 56, das von dem Transportumschlingungsmittel 16 zumindest teilweise umschlungen ist (vgl. Figuren 4 und 7). Das Antriebsrad 56 ist hierbei drehbar am Tragrahmenelement 68 gelagert. Ferner ist am Tragrahmenelement 68 zumindest ein Stützelement 72 der Transporteinheit 14 angeordnet, das das als Transportriemen ausgebildete Transportumschlingungsmittel 16, betrachtet entlang der Hochkantachse 20, zumindest teilweise überdeckt. Das Stützelement 72 bildet zudem eine seitliche Führungsfläche im Bereich des als Transportriemen ausgebildeten Transportumschlingungsmittels 16, an der die Leiterplatten 12 während eines Transports geführt werden können. Die Führungsfläche des Stützelements 72 erstreckt sich hierbei zumindest im Wesentlichen parallel zur Hochkantachse 20 und zur Transportrichtung 46. Die Transporteinheit 14 umfasst entlang einer Gesamttransportstrecke eine Vielzahl von einzelnen Abschnitten 30, 36 bzw. Teiltransporteinheiten, die jeweils einzeln für sich ein Transportumschlingungsmittel 16 umfassen, das mittels einer Antriebseinheit 54 des jeweiligen Abschnitts 30, 36 der Transporteinheit 14 antreibbar ist.

Zu einer Hochkantförderung der Leiterplatten 12 umfasst die Transporteinheit 14 zusätzlich zum Transportumschlingungsmittel 16 zumindest ein Transport- und/oder Führungselement 22, das als Führungsschiene ausgebildet ist (vgl. Figuren 2 bis 4). Hierbei weisen die Abschnitte 30, 36 bzw. Teiltransporteinheiten der Transporteinheit 14 jeweils einzeln für sich ein als Führungsschiene ausgebildetes Transport- und/oder Führungselement 22 auf. Das als Führungsschiene ausgebildete Transport- und/oder Führungselement 22 ist, betrachtet entlang der Hochkantachse 20, relativ zum Transportumschlingungsmittel 16 beabstandet angeordnet. Somit sind die Leiterplatten 12 zu einem Transport vertikal ausgerichtet zwischen dem Transportumschlingungsmittel 16 und dem als Führungsschiene ausgebildeten Transport- und/oder Führungselement 22 angeordnet. Hierbei liegen die Leiterplatten 12 jeweils mit einer Seite am Transportumschlingungsmittel 16 und jeweils mit einer weiteren Seite an dem als Führungsschiene ausgebildete Transport- und/oder Führungselement 22 an. Zu einer Einstellung eines Abstands zwischen dem Transportumschlingungsmittel 16 und dem als Führungsschiene ausgebildeten Transport- und/oder Führungselement 22 entlang der Hochkantachse 20 ist das Transport- und/oder Führungselement 22 an einem beweglich gelagerten weiteren Tragrahmenelement 58 der Transporteinheit 14 angeordnet. Das weitere Tragrahmenelement 58 ist hierbei entlang einer zumindest im Wesentlichen parallel zur Hochkantachse 20 verlaufenden Bewegungsachse 24 translatorisch beweglich am Hauptrahmenelement 70 gelagert. Somit umfasst die Vorrichtung 10 zumindest eine Hochkantabstandseinstelleinheit 60 zu einer Einstellung eines Abstands zwischen dem Transportumschlingungsmittel 16 und dem als Führungsschiene ausgebildeten Transport- und/oder Führungselement 22 entlang der Hochkantachse 20 (vgl. Figur 2). Die Hochkantabstandseinstelleinheit 60 weist ein Spindelelement (hier nicht näher dargestellt) und ein auf das Spindelelement wirkendes Bedienelement 62 auf. Das Bedienelement 62 ist dazu vorgesehen, das Spindelelement rotatorisch auf eine, einem Fachmann bereits bekannte Art und Weise anzutreiben, um einen Abstand zwischen dem Transportumschlingungsmittel 16 und dem als Führungsschiene ausgebildeten Transport- und/oder Führungselement 22 entlang der Hochkantachse 20 zu ändern bzw. einzustellen. Somit ist das als Führungsschiene ausgebildete Transport- und/oder Führungselement 22 entlang der zumindest im Wesentlichen parallel zur Hochkantachse 20 verlaufenden Bewegungsachse 24 relativ zum Transportumschlingungsmittel 16 beweglich gelagert. In einer alternativen, hier nicht dargestellten Ausgestaltung der Hochkantabstandseinstelleinheit 60 umfasst die Hochkantabstandseinstelleinheit 60 eine elektrische, pneumatische und/oder hydraulische Linearantriebseinheit, mittels derer ein Abstand zwischen dem Transportumschlingungsmittel 16 und dem als Führungsschiene ausgebildeten Transport- und/oder Führungselement 22 entlang der Hochkantachse 20 einstellbar ist.

Das als Führungsschiene ausgebildete Transport- und/oder Führungselement 22 umfasst ferner zumindest eine Führungsnut 26, in der die Leiterplatten 12 zumindest während eines Transports geführt werden (vgl. Figuren 3 und 4). Die Führungsnut 26 weist hierbei eine U-förmige Ausgestaltung auf. Es ist jedoch auch denkbar, dass die Führungsnut 26 eine andere, einem Fachmann als sinnvoll erscheinende Ausgestaltung aufweist, wie beispielsweise eine V-förmige Ausgestaltung usw. Zudem umfasst das als Führungsschiene ausgebildete Transport- und/oder Führungselement 22 zumindest eine Stütz- und/oder Transportfläche 64. Die Stütz- und/oder Transportfläche 64 ist dazu vorgesehen, zumindest eine Stütz- und/oder Haltekraft auf die Leiterplatten 12 auszuüben, deren Hauptkraftkomponente zumindest im Wesentlichen parallel zur Hochkantachse 20 verläuft. Es ist jedoch auch denkbar, dass die Stütz- und/oder Transportfläche 64 alternativ oder zusätzlich dazu vorgesehen ist, zumindest eine Stütz- und/oder Haltekraft auf die Leiterplatten 12 auszuüben, deren Hauptkraftkomponente zumindest im Wesentlichen quer zur Hochkantachse 20 verläuft. Die Stütz- und/oder Transportfläche 64 des als Führungsschiene ausgebildeten Transport- und/oder Führungselements 22 wird von einer die Führungsnut 26 begrenzenden Fläche des als Führungsschiene ausgebildeten Transport- und/oder Führungselements 22 gebildet. Das als Führungsschiene ausgebildete Transport- und/oder Führungselement 22 ist hierbei aus einem Kunststoff gebildet. Es ist jedoch auch denkbar, dass das als Führungsschiene ausgebildete Transport- und/oder Führungselement 22 aus einem Metall gebildet ist.

Des Weiteren umfasst die Vorrichtung 10 zumindest eine Schwenkeinheit 34, die dazu vorgesehen ist, zumindest einen Abschnitt 36 der Transporteinheit 14 bzw. zumindest eine Teiltransporteinheit der Transporteinheit 14 schwenkbar um eine Schwenkachse 38 zu lagern (vgl. Figuren 5 und 6). Die Schwenkachse 38 der Schwenkeinheit 34 verläuft hierbei zumindest im Wesentlichen parallel zur Hochkantachse 20 der Transporteinheit 14. Zudem verläuft die Schwenkachse 38 zumindest im Wesentlichen quer zur Transportrichtung 46 der Transporteinheit 14. Mittels einer Schwenkbewegung des Abschnitts 36 der Transporteinheit 14 bzw. der Teiltransporteinheit der Transporteinheit 14 ist eine Umlenkung oder eine Abzweigung eines Transportwegs der Leiterplatten 12 möglich. Die Schwenkeinheit 34 ist somit als Hochkantachsschwenkeinheit ausgebildet. Bei einer Schwenkbewegung des Abschnitts 36 der Transporteinheit 14 bzw. der Teiltransporteinheit der Transporteinheit 14 mittels der Schwenkeinheit 34 werden eine Teilstrecke der Transporteinheit 14, an der zumindest ein wie oben beschriebenes Transportumschlingungsmittel 16, ein wie oben beschriebenes Transport- und/oder Führungselement 22 und eine wie oben beschriebene Antriebseinheit 54 angeordnet sind, relativ zu weiteren Abschnitten der Transporteinheit 14 um die Schwenkachse 38 geschwenkt.

Zusätzlich zur Schwenkeinheit 34 umfasst die Vorrichtung 10 eine weitere Schwenkeinheit 66. Die weitere Schwenkeinheit 66 ist dazu vorgesehen, zumindest den Abschnitt 36 der Transporteinheit 14 bzw. zumindest die Teiltransporteinheit der Transporteinheit 14 schwenkbar um eine weitere Schwenkachse 40 zu lagern (vgl. Figuren 5 und 6). Die weitere Schwenkachse 40 verläuft hierbei zumindest im Wesentlichen senkrecht zur Hochkantachse 20 der Transporteinheit 14. Zudem verläuft die weitere Schwenkachse 40 zumindest im Wesentlichen quer zur Transportrichtung 46 der Transporteinheit 14. Somit ist die weitere Schwenkeinheit 66 als Flip-Schwenkeinheit ausgebildet, die dazu vorgesehen ist, die Leiterplatten 12 aus einer vertikalen Ausrichtung in eine horizontale Ausrichtung oder umgekehrt zu schwenken. Es können beispielsweise Leiterplatten 12 aus einem Horizontallagermagazin der Vorrichtung 10 entnommen werden, die mittels der weiteren Schwenkeinheit 66 in eine vertikale Ausrichtung geschwenkt werden können, um einen Transport der Leiterplatten 12 mittels der Transporteinheit 14 in einer vertikalen Ausrichtung zu ermöglichen. Bei einer Schwenkbewegung des Abschnitts 36 der Transporteinheit 14 bzw. der Teiltransporteinheit der Transporteinheit 14 mittels der weiteren Schwenkeinheit 66 werden eine Teilstrecke der Transporteinheit 14, an der zumindest ein wie oben beschriebenes Transportumschlingungsmittel 16, ein wie oben beschriebenes Transport- und/oder Führungselement 22 und eine wie oben beschriebene Antriebseinheit 54 angeordnet sind, relativ zu weiteren Abschnitten der Transporteinheit 14 um die weitere Schwenkachse 40 geschwenkt.

Des Weiteren umfasst die Vorrichtung 10 zumindest eine Linearbewegungseinheit 28, die dazu vorgesehen ist, zumindest einen weiteren Abschnitt 30 der Transporteinheit 14 bzw. zumindest eine weitere Teiltransporteinheit der Transporteinheit 14 translatorisch entlang einer Linearbewegungsachse 32 zu lagern. Die Linearbewegungsachse 32 verläuft hierbei zumindest im Wesentlichen senkrecht zur Hochkantachse 20 der Transporteinheit 14. Zudem verläuft die Linearbewegungsachse 32 zumindest im Wesentlichen quer und insbesondere senkrecht zur Transportrichtung 46 der Transporteinheit 14. Die Linearbewegungseinheit 28 ist somit als Parallelversetzungseinheit ausgebildet, die dazu vorgesehen ist, zumindest den weiteren Abschnitt 30 der Transporteinheit 14 bzw. zumindest die weitere Teiltransporteinheit der Transporteinheit 14 parallel relativ z. B. zum Abschnitt 36 der Transporteinheit 14 bzw. der Teiltransporteinheit der Transporteinheit 14 zu versetzen, um beispielsweise zwei parallel zueinander verlaufende Transportstrecken miteinander zu verbinden bzw. eine Übergabe der Leiterplatten 12 zwischen zwei parallel zueinander verlaufenden Transportstrecken zu ermöglichen. Bei einer translatorischen Bewegung des weiteren Abschnitts 30 der Transporteinheit 14 bzw. der Teiltransporteinheit der Transporteinheit 14 mittels der Linearbewegungseinheit 28 werden eine Teilstrecke der Transporteinheit 14, an der zumindest ein wie oben beschriebenes Transportumschlingungsmittel 16, ein wie oben beschriebenes Transport- und/oder Führungselement 22 und eine wie oben beschriebene Antriebseinheit 54 angeordnet sind, relativ zu weiteren Abschnitten der Transporteinheit 14 entlang der Linearbewegungsachse 32 translatorisch bewegt.

Die Leiterplatten 12 sind mittels der Transporteinheit 14 der Hochkantbestückungseinheit 44 hochkant zuführbar. In der Hochkantbestückungseinheit 44 sind die Leiterplatten 12, wie bereits oben beschrieben, in einer hochkant angeordneten Position bestückbar. Zudem sind die Leiterplatten 12 mittels der Transporteinheit 14 der Hochkantprüfeinheit 42 hochkant zuführbar. In der Hochkantprüfeinheit 42 sind die Leiterplatten 12, wie bereits oben beschrieben, in einer hochkant angeordneten Position prüfbar. Somit benötigt die Vorrichtung 10 einen geringen Raum in einer Fertigungshalle um einen Transport oder einen Transport und eine Bearbeitung von Leiterplatten 12 zu realisieren.

## Patentansprüche

1. Vorrichtung zu einem Transport oder zu einem Transport und zu einer Bearbeitung von Leiterplatten (12), mit zumindest einer Transporteinheit (14), die zu einer Hochkantförderung, bei der Leiterplatten (12) während eines Transports entlang einer Transportrichtung (46) der Transporteinheit (14) vertikal ausgerichtet sind, vorgesehen ist und die zumindest ein Transportumschlingungsmittel (16) aufweist, das zu einer Übertragung von Antriebskräften ein Antriebselement zumindest teilweise umschlingt und vom Antriebselement antreibbar ist, wobei das Transportumschlingungsmittel (16) zumindest eine Transportlagerfläche (18) zur Abstützung der Leiterplatten (12) zumindest während eines Transports aufweist, **gekennzeichnet durch** zumindest eine Schwenkeinheit (34), die zumindest einen Abschnitt (36) der Transporteinheit (14) schwenkbar um eine Schwenkachse (38, 40) lagert,
wobei bei einer Schwenkbewegung des Abschnitts (36) der Transporteinheit (14) mittels der Schwenkeinheit (34) eine Teilstrecke der Transporteinheit (14), an der zumindest das Transportumschlingungsmittel (16), ein Transport- und/oder Führungselement (22) der Transporteinheit (14) und eine Antriebseinheit (54) der Transporteinheit (14) angeordnet sind, relativ zu weiteren Abschnitten der Transporteinheit (14) um die Schwenkachse (38) schwenkbar ist.

2. Vorrichtung nach Anspruch 1, **dadurch gekennzeichnet, dass** die Transportlagerfläche (18) zumindest im Wesentlichen senkrecht zu einer Hochkantachse (20) der Transporteinheit (14) verläuft.

3. Vorrichtung nach einem der vorhergehenden Ansprüche, **dadurch gekennzeichnet, dass** das Transportumschlingungsmittel (16) als Transportriemen ausgebildet ist, der einen polygonalen Querschnitt aufweist.

4. Vorrichtung nach einem der vorhergehenden Ansprüche, **dadurch gekennzeichnet, dass** die Transporteinheit (14) zumindest das Transport- und/oder Führungselement (22) aufweist, das als Führungsschiene ausgebildet ist.

5. Vorrichtung nach Anspruch 4, **dadurch gekennzeichnet, dass** das als Führungsschiene ausgebildete Transport- und/oder Führungselement (22) entlang einer zumindest im Wesentlichen parallel zur Hochkantachse (20) verlaufenden Bewegungsachse (24) relativ zum Transportumschlingungsmittel (16) beweglich gelagert ist.

6. Vorrichtung zumindest nach Anspruch 4, **dadurch gekennzeichnet, dass** das als Führungsschiene ausgebildete Transport- und/oder Führungselement (22) zumindest eine Führungsnut (26) umfasst, in der die Leiterplatten (12) zumindest während eines Transports geführt werden.

7. Vorrichtung nach einem der vorhergehenden Ansprüche, **gekennzeichnet durch** zumindest eine Linearbewegungseinheit (28), die dazu vorgesehen ist, zumindest einen Abschnitt (30) der Transporteinheit (14) translatorisch entlang einer Linearbewegungsachse (32) zu lagern.

8. Vorrichtung nach einem der vorhergehenden Ansprüche, **gekennzeichnet durch** zumindest eine Hochkantprüfeinheit (42), der die Leiterplatten (12) mittels der Transporteinheit (14) hochkant zuführbar sind und mittels derer die Leiterplatten (12) in einer hochkant angeordneten Position prüfbar sind.

9. Vorrichtung nach einem der vorhergehenden Ansprüche, **gekennzeichnet durch** zumindest eine Hochkantbestückungseinheit (44), der die Leiterplatten (12) mittels der Transporteinheit (14) hochkant zuführbar sind und mittels derer die Leiterplatten (12) in einer hochkant angeordneten Position bestückbar sind.

## Claims

1. Device for transporting, or for transporting and for processing, printed circuit boards (12), with at least one transport unit (14) which is provided for an upright conveyance in which printed circuit boards (12) are oriented vertically during a transport along a transporting direction (46) of the transport unit (14) and which transport unit (14) comprises at least one wraparound conveyor element (16) which for transmitting drive forces at least partially wraps a drive element and is driveable by the drive element, the wraparound conveyor element (16) comprising at least one transporting bearing surface (18) for supporting the printed circuit boards (12) at least during a transport, **characterised by** at least one pivot unit (34), which supports at least one portion (36) of the transport unit (14) pivotably around a pivot axis (38, 40) wherein, in a pivoting movement of the portion (36) of the transport unit (14), a partial length of the transport unit (14), on which at least the wraparound conveyor element (16), a transporting and/or guide element (22) of the transport unit (14) and a drive unit (54) of the transport unit (14) are arranged, is pivotable around the pivot axis (38) with respect to further portions of the transport unit (14) by means of the pivot unit (34).

2. Device according to Claim 1, **characterised in that** the transporting bearing surface (18) extends at least substantially perpendicular to an upright axis (20) of the transport unit (14).

3. Device according to one of the preceding Claims, **characterised in that** the wraparound conveyor element (16) is embodied as a transport belt having a polygonal cross section.

4. Device according to one of the preceding Claims, **characterised in that** the transport unit (14) comprises at least the transporting and/or guide element (22), which is embodied as a guide rail.

5. Device according to Claim 4, **characterised in that** the transporting and/or guide element (22) embodied as a guide rail is supported movably with respect to the wraparound conveyor element (16) along a motion axis (24) that extends at least substantially parallel to the upright axis (20).

6. Device at least according to Claim 4, **characterised in that** the transporting and/or guide element (22) embodied as a guide rail comprises at least one guide groove (26), in which the printed circuit boards (12) are guided at least during a transport.

7. Device according to one of the preceding Claims, **characterised by** at least one linear motion unit (28), which is provided for supporting at least one section (30) of the transport unit (14) translationally along a linear movement axis (32).

8. Device according to one of the preceding Claims, **characterised by** at least one upright checking unit (42), to which the printed circuit boards (12) are conveyable upright via the transport unit (14) and by means of which the printed circuit boards (12) can be checked in an upright arranged position.

9. Device according to one of the preceding Claims, **characterised by** at least one upright loading unit (44), to which the printed circuit boards (12) are conveyable upright via the transport unit (14) and by means of which the printed circuit boards (12) can be loaded in an upright arranged position.

## Revendications

1. Dispositif pour un transport, ou pour un transport et un traitement de plaques conductrices (12), avec au moins une unité de transport (14) prévue pour un convoyage debout, dans lequel de plaques conductrices (12) sont orientées verticalement au cours d'un transport le long d'une direction de transport (46) d'une unité de transport (14), laquelle unité de transport (14) comportant au moins un moyen-transport enroulant (16), lequel enroule pour le but d'un transfert de forces de propulsion au moins partiellement un élément de propulsion et est pro-pulsable par le biais de l'élément de propulsion, le moyen-transport enroulant (16) comportant au moins une surface-transport supportant (18) pour appuyer les plaques conductrices (12) au moins au cours d'un transport, **caractérisé par** au moins une unité de pivot (34), laquelle supporte au moins une section (36) de l'unité de transport (14) pivotablement autour d'un axe pivotant (38, 40),
un trajet partiel de l'unité de transport (14), auquel sont disposés au moins le moyen-transport enroulant (16), un élément de transport et/ou de guidage (22) de l'unité de transport (14) et une unité de propulsion (54) de l'unité de transport (14), étant pivotable, relativement à d'autres sections de l'unité de transport (14), autour de l'axe pivotant (38) par le biais de l'unité de pivot (34) en cas d'un mouvement pivotant de la section (36) de l'unité de transport (14).

2. Dispositif selon la revendication 1, **caractérisé en ce que** la surface-transport supportant (18) s'étend au moins substantiellement de manière perpendiculaire à un axe debout (20) de l'unité de transport (14).

3. Dispositif selon l'une quelconque des revendications précédentes, **caractérisé en ce que** le moyen-transport enroulant (16) est implémenté comme courroie de transport ayant une section transversale polygonale.

4. Dispositif selon l'une quelconque des revendications précédentes, **caractérisé en ce que** l'unité de transport (14) comporte au moins l'élément de transport et/ou de guidage (22), lequel est implémenté comme rail de guidage.

5. Dispositif selon la revendication 4, **caractérisé en ce que** l'élément de transport et/ou de guidage (22) implémenté comme rail de guidage est supporté le long d'un axe me mouvement (24) s'étendant au moins substantiellement en parallèle à l'axe debout (20) de manière mobile relatif au moyen-transport enroulant (16).

6. Dispositif au moins selon la revendication 4, **caractérisé en ce que** l'élément de transport et/ou de guidage (22) implémenté comme rail de guidage comporte au moins une rainure de guidage (26), dans laquelle les plaques conductrices (12) sont guidées au moins au cours d'un transport.

7. Dispositif selon l'une quelconque des revendications précédentes, **caractérisé par** au moins une unité de mouvement linéaire (28), laquelle est prévue à supporter au moins une section (30) de l'unité de transport (14) de manière translationelle le long d'un axe de mouvement linéaire (32).

8. Dispositif selon l'une quelconque des revendications précédentes, **caractérisé par** au moins une unité debout d'examination (42), à laquelle les plaques conductrices (12) peuvent être convoyées debout par le biais de l'unité de transport (14) et par le biais de laquelle les plaques conductrices (12) peuvent être examinées dans une position disposée debout.

9. Dispositif selon l'une quelconque des revendications précédentes, **caractérisé par** au moins une unité debout de garnissage (44), à laquelle les plaques conductrices (12) peuvent être convoyées debout par le biais de l'unité de transport (14) et par le biais de laquelle les plaques conductrices (12) peuvent être garnies dans une position disposée debout.
